# EUROPEAN PATENT SPECIFICATION

(11) **EP 1 255 356 B1**
(45) Date of publication and mention of the grant of the patent: **22.07.2009**
(21) Application number: 01110681.2
(22) Date of filing: 02.05.2001
(51) Int. Cl.: H03L 7/23, H03L 7/185

(54) **Dual mode/triple band frequency synthesiser**
Dualmode-Dreiband-Frequenzsynthesizer
Synthétiseur de fréquence bi-mode / triple bande

(43) Date of publication of application: 06.11.2002
(73) Proprietor: Sony Deutschland GmbH, 10785 Berlin (DE)
(72) Inventor: Itkin, Grigory, Digital Telecommunications Europe, 85609 Aschheim (DE)
(74) Representative: Körber, Martin Hans

(56) References cited:
- WO-A-00/55981
- WO-A-99/52221
- US-A- 5 373 256
- US-A- 6 161 000
- PATENT ABSTRACTS OF JAPAN vol. 2000, no. 03, 30 March 2000 (2000-03-30) -& JP 11 355138 A (HITACHI LTD), 24 December 1999 (1999-12-24)

## Description

The present invention relates to a frequency synthesiser for providing all necessary receiving and transmitting frequencies for wireless telecommunication systems according to the GSM (Global System for Mobile Telecommunication) and UMTS (Universal Mobile Telephone System) standards.

The present invention relates further to a mobile terminal, like a mobile telephone or a personal digital assistant (PDA), for a wireless telecommunication system according to the GSM and/or UMTS standards comprising such a frequency synthesiser.

Since the above-mentioned telecommunication systems work over air-interfaces in different frequency ranges, the frequency ranges for the respective telecommunication system have to be generated for modulating and demodulating signals, which have to be transmitted and received according to these standards.

The specific frequency ranges are: 925 to 960 MHz for EGSM (extended GSM), 1805 to 1880 MHz for GSM 1800, 1930 to 1990 MHz for GSM 1900 in the receiving mode and 880 to 915 MHz for EGSM, 1710 to 1785 MHz for GSM 1800 and 1850 to 1910 for GSM 1900 in the transmitting mode. Further, the frequency range for UMTS is 1900 to 2025 MHz applies to the receiving as well as the transmitting mode. The described frequency ranges are valid for a TDD (Time Division Duplex) system.

For an FDD (Frequency Division Duplex) system the frequency range for UMTS is 2110 to 2170 MHz in the receiving mode and 1920 to 1980 MHz in the transmitting mode.

In the prior art transceivers are known, which are capable to transmit/receive signals in the GSM system and also for satellite networks. However, these transceivers demodulate the received signals into an intermediate frequency band for a subsequent demodulating the signals into the base bands. This has the disadvantage that a relatively high quantity of electronic devices is necessary, which increases the required space, the power consumption and the cost.

Further, in the prior art several frequency synthesisers are used for generating the respective frequency ranges for GSM and UMTS. This has also the disadvantage that the required space, the power consumption and the costs are increased when providing a mobile terminal with GSM as well as UMTS functionality.

Moreover, document US Patent 5,373,256 by Nicotra et al. discloses a frequency synthesis system for generating microwaves which includes a main loop with a low gain electronically tunable voltage controlled oscillator (VCO) covering the entire desired frequency bandwidth, and a secondary loop including a direct synthesis section in which frequencies are synthesized directly from a quartz reference which also controls the stability of the oscillator and an indirect synthesis section with a high gain oscillator. Of particular interest is a three loop circuit shown in Fig. 3.

It is therefore the object of the present invention to provide a frequency synthesiser which is suitable for mobile terminals operating according to GSM and UMTS standards and which is realised with a minimum quantity of electronic parts.

This object is achieved by a frequency synthesiser for providing, receiving and transmitting frequencies for wireless telecommunication systems according to the GSM and UMTS standards according to claim 1.

According to the present invention the necessary frequencies, which are suitable for a mobile dual mode (UMTS and GSM) terminal for wireless telecommunication systems, are generated by the frequency synthesiser according to the present invention.

Favorably, the first output signal has a frequency according to the formula LO1±LO3'+LO2/M1xN1.
Favorably, the second output signal has a frequency according to the formula LO1+LO3'+LO2/M2xN2.

Favorably, the signal generating means comprises a third oscillating means, which generates a signal with a frequency L03, whereby the third signal (L03') is derived from the signal with the frequency L03.
Favorably, the signal generating means comprises a fifth dividing means (23) for dividing the signal (L03) generated by the third oscillating means. Favorably, the fifth dividing means divides the signal (L03) generated by the third oscillating means by 16. This has the advantage, that the third signal LO3' can be varied in relatively small frequency steps at the same time.

Favorably, the signal generating means comprises a switching means (24) for generating signals, which are phase-delayed. This has the advantage, that the third signal can be directly used with a modulating means (second and fourth modulating means), which is a so-called single side or image reject modulator.

Favorably, the switching means generates phase-delayed IQ-signals.
Favorably, the output signals of the switching means are equal to the third signal (L03').

Favorably, the first oscillating means generates the first signal with a frequency LO1 in the frequency range of 1540 to 1600 MHz, the second oscillating means generates the second signal with the frequencies L02 456, 490,4 and 539,2 MHz and the signal generating means generates the third signal with a frequency L03' in the frequency range of 7,5 to 10 MHz.
Favorably, the frequency synthesiser provides the frequency in GSM standard for EGSM, GSM 1800, GSM 1900.

Moreover, a mobile terminal for a wireless telecommunication system according to the GSM-and/or UMTS-standard is disclosed comprising a frequency synthesiser as mentioned above.

The advantage of the present invention is, that all receiving and transmitting frequencies needed for a mobile dual mode terminal are generated by the same frequency synthesiser. Therefore, the generating of the necessary frequencies for dual mode terminals can be realised by a minimum of electronic circuitry, cost and required space.

Further, the first and second oscillating means and the signal generating means, which are advantageously phase locked loops for generating the signals, can operate with a relative narrow bandwidth and can be operated with high comparation frequencies. This leads to a high signal to noise ration (S/N-ratio) and fast frequency hopping between the different frequencies.

Further advantageously, the reference signal means generates a reference signal of 19.2 MHz based on a quartz oscillator.

Thus, the frequency synthesiser according to the present invention provides the frequencies for transmitting (Tx) and receiving (Rx) signals to the GSM and UMTS standards. Thereby, the frequencies for triple band terminal for GSM are provided as follows: EGSM (Extended GSM, frequency range 880 to 915 MHz Tx, 925 to 960 MHz Rx), DCS (Digital Cellular System, also called GSM1800, frequency range 1710 to 1785 MHz Tx, 1805 to 1880 MHz Rx) and PCS (Personal Communication system, also called GSM1900, frequency range 1850 to 1910 MHz Tx and 1930 to 1990 MHz Rx).

It is noted that the frequency which is output by the first offset loop for transmission to the EGSM standard has to be divided by two after outputting by the first offset loop, since the output frequency which is directly output by the first offset loop is in range from 1760 to 1830 MHz for transmission (Tx) and 1850 to 1920 for receiving (Rx).

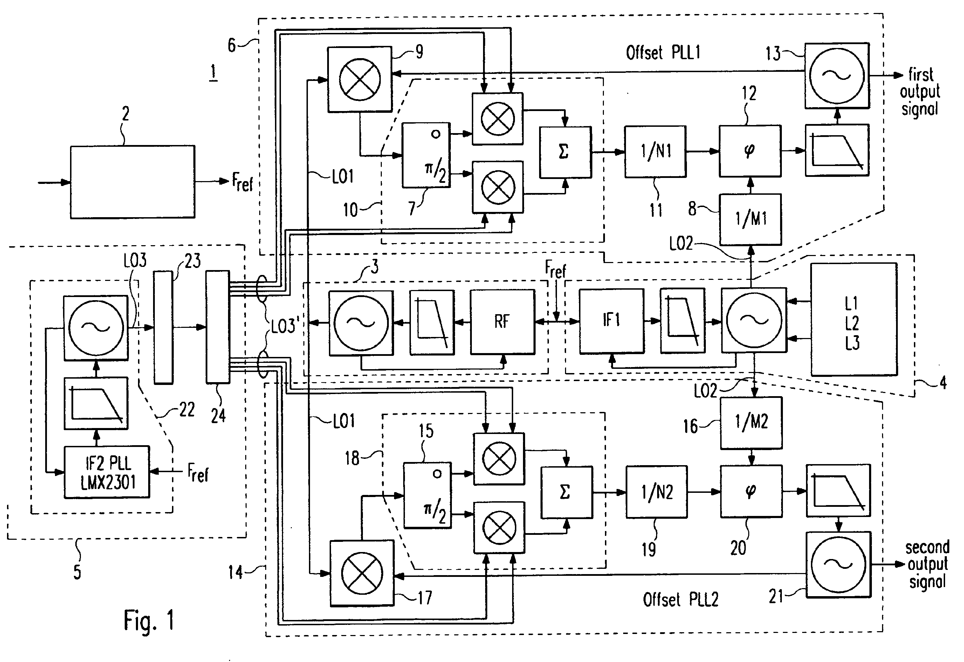

In the following description a preferred embodiment of the present invention is explained in more detail with reference to the enclosed drawing, in which
Fig. 1 shows a block diagram of an electronic circuit comprised in a frequency synthesiser according to the present invention.

The frequency synthesiser 1 according to the present invention, as shown in Fig. 1, comprises a reference signal means 2 which provides a reference signal F_{ref} with a predetermined frequency, in this embodiment F_{ref}=19.2 MHz.

The frequency synthesiser 1 further comprises a first oscillating means 3, a second oscillating means 4 and a third oscillating means 22. Those three oscillating means 3, 4, 22 are generating signals, which serve as a basis for generating the first and the second output signal.

The first, second and third oscillating means 3, 4, 22 are respectively built up with a phase locked loop-circuitry (RF, IF1, IF2), a low path filter for filtering parasitic frequencies and voltage controlled oscillator (VCO), which is controlled by the respective phase locked loop (PLL) and which outputs the signals with the respective frequency LO1, LO2, LO3.

The phase locked loops can be commercial devices, for example the dual RF/IF PLL frequency synthesiser ADS 4212(3), which comprises both PLL's for realising the first and second oscillating means 3 and 4 for intermediate frequency (IF1) and radio frequency (RF). The phase locked loop for realising the third oscillating means 22 can e.g. be a frequency synthesiser of the type LMX 2301 for intermediate frequency (IF2).

The three oscillating means 3, 4, 22 are operating with a respective comparation frequency, which is derived from the reference signal divided by a respective divisor; this pre-division is programmable and carried out by the respective PLL.

In the shown embodiment the first oscillating means 3 operates with a comparation frequency of 4.8 MHz (19.2 MHz divided by 4), the second oscillating means 4 has the comparation frequency of 2.4 MHz (19.2 MHz divided by 8) and the third oscillating means 22 has a comparation frequency of 3.2 MHz (19.2 MHz divided by 6).

Starting from the comparation frequency, the oscillating means generate the signals with the respective frequencies in a known manner by programmable frequency dividing means, which are integrated in the respective circuitry (chips). Thereby, the stepwidth of the frequency, within which the frequencies can be varied, are dependent on the comparation frequency; the higher the comparation frequency, the higher the frequency steps.

The first oscillating means 3 operates in a frequency range with a very narrow bandwidth from 1540 to 1600 MHz.

The second oscillating means 4 generates three frequencies, namely 456 MHz, 490.4 MHz and 539.2 MHz. The second signal with the frequency LO2 generated by the second oscillating means 4 transfers the first signal with the frequency LO1 into the range of the frequency of the first and the second output signal, respectively.

Since the second oscillating means 4 can output signals with only three frequencies, it can be realised with a VCO with a narrow frequency bandwidth; the respective frequency of the VCO is realised by switched inductors L1, L2, L3.

The fine tuning of the frequency of the output signal takes place by the signal generating means 5. Since the third oscillating means 22 operates with a comparation frequency of 3.2 MHz and to the output signal with the frequency LO3 is divided by 16 by a fifth dividing means 23, the signal generating means 5 generates a signal with a frequency LO3' in the frequency range of 7.5 to 10 MHz in frequency steps of 200 kHz.

The signal generating means 5 further comprises a switching means 24. The switching means 24 generates signals, which have the frequency LO3' and are suitable for using with single side modulators, e.g. digital IQ signals, comprising the in-phase and the quadrature-components of the signal LO3. For using with single side modulators, two IQ-signals are needed, which are ± 90 degree (± π/2) phase-delayed against each other.

To generate the needed frequency of the output signal, the first, second and third signal LO1, LO2 and LO3' are modulated with each other in a convenient manner by the first offset loop 6 for generating the first output signal and the second offset loop 14 for generating the second output signal.

The first offset loop 6 comprises a first dividing means 8, a first modulating means 9, a second modulating means 10, a second dividing means 11, a first phase comparator 12 and a first voltage controlled oscillator 13. The second modulating means 10 comprises a first phase shifting means as well as modulators and a means for generating the sum of two signals.

The first signal LO1 is modulated by the first modulating means 9 with the first output signal, which is generated by the first voltage controlled oscillator 13 and back-coupled from the output of the first offset loop 6 to the first modulating means 9.

The output signal of the first modulating means 9 is modulated with the signal LO3' by the second modulating means 10.

To reject unwanted mirror frequencies, the second modulating means is advantageously a so-called a single side modulator or an image reject modulator.

Therefore, the signal which is output by the first modulating means 9 is split by the first phase shifting means 7 in one signal, which is not phase-delayed in relation to the input signal of the first phase shifting means 7, and in one signal, which is π/2 phase-delayed in relation to the input signal of the first phase shifting means 7. Both signals are output to respective one modulator and modulated with the phase-delayed IQ-signals. The output signals of the respective modulators are summed. The sum of the signals contain, in a way if the above-mentioned phase-delay is positive or negative, the upper or the lower side band of the modulated signal.

The output signal of the second modulating means 10 is output to the second dividing means 11, which divides the frequency of the signal by the divisor N1 and output to the first phase comparator 12.

The second signal LO2 is divided by the first dividing means 8 by M1 and also output to the phase comparator 12.

The first phase comparator 12 compares both divided signals and regulates the first voltage controlled oscillator 13 in a way, that both input signals of the first phase comparator 12 have the same frequency.

The first offset loop 6 generates a first output signal, which has a frequency fₒᵤₜ₁ according to the formula fₒᵤₜ₁=LO1±LO3'+LO2/M1×N1. The algebraic sign of LO3' is thereby dependent on the phase-delay of the signals LO3'.

The second offset loop 14 comprises a second phase shifting means 15, a third dividing means 16 for dividing the second signal LO2 by M2, a third modulating means 17, a fourth modulating means 18, a fourth dividing means 19, which divides the signal output by the fourth modulating means 19 by N2, a second phase comparator 20 and a second voltage controlled oscillator 21.

Since both offset loops operate in the same way, the function of the second offset loop 14 will not be described again.

According to the first offset loop 6, the second offset loop 14 generates a second output signal, which has a frequency fₒᵤₜ₂ according to the formula fₒᵤₜ₂=LO1±LO3'+LO2/M2×N2.

The first offset loop 6 generates all transmitting and receiving frequencies which are necessary for EGSM, DCS (GSM 1800) and PCS (GSM 1900) standards, since these standards are operating in TDD (Time Division Duplex) mode. Further, the first offset loop generates the transmitting and receiving frequencies for UMTS standard, when operating in TDD mode, and only the transmitting frequencies for UMTS in FDD (Frequency Division Duplex) mode.

The second offset loop 14 generates only the receiving frequencies for UMTS, when operating in FDD mode, since the respective receiving and transmitting frequency is needed at the same time.

It is noted, that the described frequency synthesiser 1 generates the two-fold frequency for EGSM, that means, that the first output frequency has to be divided by two by a suitable divider, when providing frequencies for the EGSM standard.

Thus, all necessary frequencies are generated by the first and the second offset loops by suitable combining of the respective frequencies LO1, LO2 and LO3' and by programming the dividing coefficients N1, M1, N2 and M2.

The following tables show the transmitting (Tx) and receiving (Rx) frequencies for UMTS in FDD- and TDD-system and the transmitting and receiving frequencies for GSM in TDD-system; all frequencies are in MHz:

**UMTS FDD1:**

| **Tx-Rx sep.** | Tx freq. | N1 | M1 | N2 | M2 | L02 | L01±LO3' | Rx freq. | F PD1 | F PD2 |
|---|---|---|---|---|---|---|---|---|---|---|
| 190 | 1920 | 5 | 6 | 5 | 4 | 456 | 1540 | 2110 | 76 | 38 |
| 190 | 1980 | 5 | 6 | 5 | 4 | 456 | 1600 | 2170 | 76 | 38 |

**UMTS FDD2:**

| **Tx-Rx sep.** | Tx freq. | N1 | M1 | N2 | M2 | L02 | L01±L03' | Rx freq. | F PD1 | F PD2 |
|---|---|---|---|---|---|---|---|---|---|---|
| 134.8 | 1975.2 | 3 | 4 | 4 | 4 | 539.2 | 1570.8 | 2110 | 134.8 | 33.7 |
| 134.8 | 1980 | 3 | 4 | 4 | 4 | 539.2 | 1575.2 | 2114.8 | 134.8 | 33.7 |

**UMTS FDD3:**

| **Tx-Rx sep.** | Tx freq. | N1 | M1 | N2 | M2 | L02 | L01±LO3' | Rx freq. | F PD1 | F PD2 |
|---|---|---|---|---|---|---|---|---|---|---|
| 245.2 | 1920 | 3 | 4 | 5 | 4 | 490.4 | 1552.2 | 2165.2 | 122.6 | 49.04 |
| 245.2 | 1924.8 | 3 | 4 | 5 | 4 | 490.4 | 1557 | 2170 | 122.6 | 49.04 |

The column "Tx-Rx sep." shows the difference between the receiving frequency "Rx freq." and transmitting frequency "Tx freq.", N1, N2, M1, M2 the coefficients for the dividing means one to four 8, 11, 16, 19. Further, the table shows the frequency of the three signals LO1, LO2 LO3', which had to be adjusted to get the respective output frequency. Thereby, the specific frequencies of the first signal LO1 and the third signal LO3' are not critical, since the sum and difference, respectively, of those signals are important.

The columns "F PD1" and "F PD2" shows examples of the clock frequencies, by which the first phase comparator 12 and the second phase comparator 20 are provided with. Due to the high clock frequencies, the phase comparators enables a very fast regulating of the output frequencies (first and second output frequency).

**UMTS TDD:**

| **Tx/Rx freq.** | N1 | M1 | L02 | L01±L03' | F PD1 |
|---|---|---|---|---|---|
| 1900 | 3 | 4 | 456 | 1558 | 114 |
| 1920 | 3 | 4 | 456 | 1578 | 114 |
| 2010 | 4 | 4 | 456 | 1554 | 114 |
| 2025 | 4 | 4 | 456 | 1569 | 114 |

**(EGSM-Tx) × 2:**

| **Tx freq.** | N1 | M1 | L02 | L01±L03' | F PD1 |
|---|---|---|---|---|---|
| 1760 | 2 | 5 | 456 | 1577.6 | 91.2 |
| 1782 | 2 | 5 | 456 | 1599.6 | 91.2 |
| 1782 | 2 | 4 | 456 | 1554 | 114 |
| 1828 | 2 | 4 | 456 | 1600 | 114 |
| 1828 | 3 | 5 | 456 | 1554.4 | 91.2 |
| 1830 | 3 | 5 | 456 | 1556.4 | 91.2 |

**(EGSM-Rx) × 2:**

| **Rx freq.** | N1 | M1 | L02 | L01±L03' | F PD1 |
|---|---|---|---|---|---|
| 1850 | 5 | 8 | 456 | 1565 | 57 |
| 1885 | 5 | 8 | 456 | 1600 | 57 |
| 1885 | 3 | 4 | 456 | 1543 | 114 |
| 1920 | 3 | 4 | 456 | 1578 | 114 |

**GSM 1800- (DCS-) Tx:**

| **Tx freq.** | N1 | M1 | L02 | LO1±LO3' | F PD1 |
|---|---|---|---|---|---|
| 1710 | 2 | 6 | 456 | 1558 | 76 |
| 1752 | 2 | 6 | 456 | 1600 | 76 |
| 1752 | 2 | 5 | 456 | 1569.6 | 91.2 |
| 1782 | 2 | 5 | 456 | 1599.6 | 91.2 |
| 1782 | 2 | 4 | 456 | 1554 | 114 |
| 1785 | 2 | 4 | 456 | 1557 | 114 |

**GSM 1800- (DCS-) Rx:**

| **Rx freq.** | N1 | M1 | L02 | L01±L03' | F PD1 |
|---|---|---|---|---|---|
| 1805 | 2 | 4 | 456 | 1577 | 114 |
| 1828 | 2 | 4 | 456 | 1600 | 114 |
| 1828 | 3 | 5 | 456 | 1554.4 | 91.2 |
| 1873 | 3 | 5 | 456 | 1599.4 | 91.2 |
| 1873 | 5 | 8 | 456 | 1588 | 57 |
| 1880 | 5 | 8 | 456 | 1595 | 57 |

**GSM 1900- (PCS-) Tx:**

| **Tx freq.** | N1 | M1 | L02 | L01±L03' | F PD1 |
|---|---|---|---|---|---|
| 1850 | 5 | 8 | 456 | 1565 | 57 |
| 1885 | 5 | 8 | 456 | 1600 | 57 |
| 1885 | 6 | 8 | 456 | 1543 | 57 |
| 1910 | 6 | 8 | 456 | 1568 | 57 |

**GSM 1900- (PCS-) Rx:**

| **Rx freq.** | N1 | M1 | L02 | L01±L03' | F PD1 |
|---|---|---|---|---|---|
| 1930 | 3 | 4 | 456 | 1588 | 114 |
| 1942 | 3 | 4 | 456 | 1600 | 114 |
| 1942 | 7 | 8 | 456 | 1543 | 57 |
| 1990 | 7 | 8 | 456 | 1591 | 57 |

The advantage of the present invention is, that the PLL's of the three oscillating means are operating with relative high comparation frequencies to achieve a high S/N-ratio (Signal to Noise ratio) and a fast frequency hopping. A fast frequency hopping is also be attained by the second oscillating means 2, since it generates just signals with three different frequencies.

Further, since the signal of the third oscillating means 22 is divided by 16 by the fifth dividing means 23, the output frequencies are adjustable with in very low frequency steps, i.e. 200kHz in the shown embodiment of the present invention.

Thus, the frequency synthesiser according to the present invention is easy and cheap to realise.

## Claims

1. Frequency synthesiser (1) for providing receiving and transmitting frequencies for wireless telecommunication systems according to the GSM- and UMTS-standard, comprising
a reference signal means (2) for generating a reference signal (F_{ref}) with a predetermined frequency,
a first oscillating means (3) for generating a first signal with a frequency LO1 on the basis of the reference signal (F_{ref}),
a second oscillating means (4) for generating a second signal with a frequency L02 on the basis of the reference signal (F_{ref}),
a signal generating means (5) for generating a third signal with a frequency L03' on the basis of the reference signal (F_{ref}), and
a first offset loop (6) for generating a first output signal on the basis of the first, second and third signal,
wherein the first offset loop (6) comprises
a first dividing means (8) for dividing the second signal by M1,
a first modulating means (9) for modulating the first output signal by the first signal (LO1), and
a second modulating means (10) for modulating the signal, which is generated by the first modulating means (9), by the third signal (LO3'),
**characterised in**
**that** the First offset loop (6) further comprises
a second dividing means (11) for dividing the signal, which is generated by the second modulating means (10), by N1, and
a first phase comparator (12) for comparing the second signal divided by M1 with the signal, which is generated by the second modulating means (10), divided by N1, and for regulating the frequency of the first output signal on the basis of the comparison and
**that** the frequency synthesizer (1) comprises
a second offset loop (14) for generating a second output signal on the basis of the first, second and third signal (LO1, LO2 and LO3'),
wherein the second offset loop (14) comprises
a third dividing means (16) for dividing the second signal by M2,
a third modulating means (17) for modulating the second output signal by the first signal (LO1),
a fourth modulating means (18) for modulating the signal, which is generated by the third modulating means (17), by the third signal (LO3'),
a fourth dividing means (19) for dividing the signal, which is generated by the fourth modulating means (18), by N2, and
a second phase comparator (20) for comparing the second signal (LO2) divided by M2 with the signal, which is generated by the fourth modulating means (18), divided by N2, and for regulating the frequency of the second output signal on the basis of the comparison.

2. Frequency synthesiser (1) according to claim 1,
**characterised in**
**that** the first output signal has a frequency according to the formula LO1+LO3'+LO2/M1xN1.

3. Frequency synthesiser (1) according to claim 1 or 2,
**characterised in**
**that** the second output signal has a frequency according to the formula LO1+LO3'+LO2/M2xN2.

4. Frequency synthesiser (1) according to one of the claims 1 to 3,
**characterised in**
**that** the signal generating means (5) comprises a third oscillating means (22), which generates a signal with a frequency L03, whereby the third signal (L03') is derived from the signal with the frequency L03.

5. Frequency synthesiser (1) according to claim 4,
**characterised in**
**that** the signal generating means (5) comprises a fifth dividing means (23) for dividing
the signal (LO3) generated by the third oscillating means (22).

6. Frequency synthesiser (1) according to claim 5,
**characterised in**
**that** the fifth dividing means (23) divides the signal (LO3) generated by the third oscillating means (22) by 16.

7. Frequency synthesiser (1) according to one of the claims 1 to 6,
**characterised in**
**that** the signal generating means (5) comprises a switching means (24) for generating signals, which are phase-delayed.

8. Frequency synthesiser (1) according to claim 7,
**characterised in that**
the switching means (24) generates phase-delayed IQ-signals.

9. Frequency synthesiser (1) according to claim 7 or 8,
**characterised in**
**that** the output signals of the switching means (24) are equal to the third signal (LO3').

10. Frequency synthesiser (1) according to one of the claims 1 to 9,
**characterised in**
**that** the first oscillating means (3) generates the first signal with a frequency LO1 in the frequency range of 1540 to 1600 MHz, the second oscillating means (4) generates the second signal with the frequencies LO2 456, 490,4 and 539,2 MHz and the signal generating means (5) generates the third signal with a frequency LO3' in the frequency range of 7,5 to 10 MHz.

11. Frequency synthesiser (1) according to one of the claims 1 to 10,
**characterised in**
**that** the frequency synthesiser (1) provides the frequency in GSM standard for EGSM, GSM 1800, GSM 1900.

12. Mobile terminal for a wireless telecommunication system according to the GSM-and/or UMTS-standard comprising
a frequency synthesiser (1) according to one of the preceding claims.

## Patentansprüche

1. Frequenz-Synthesizer (1) zum Bereitstellen von Empfangs- und Übertragungsfrequenzen für drahtlose Telekommunikationssysteme gemäß dem GSM-und UMTS-Standard, der umfasst:
eine Referenzsignaleinrichtung (2) zum Erzeugen eines Referenzsignals (F_{ref}) mit einer vorher festgelegten Frequenz,
eine erste Oszillatoreinrichtung (3) zum Erzeugen eines ersten Signals mit einer Frequenz LO1 auf Basis des Referenzsignals (F_{ref}),
eine zweite Oszillatoreinrichtung (4) zum Erzeugen eines zweiten Signals mit einer Frequenz LO2 auf Basis des Referenzsignals (F_{ref}),
eine Signalerzeugungseinrichtung (5) zum Erzeugen eines dritten Signals mit einer Frequenz LO3' auf Basis des Referenzsignals (F_{ref}), und
eine erste Offset-Schleife (6) zum Erzeugen eines ersten Ausgangssignals auf Basis des ersten, zweiten und dritten Signals,
wobei die erste Offset-Schleife (6) umfasst:
eine erste Teilereinrichtung (8) zum Teilen des zweiten Signals durch M1, eine erste Modulationseinrichtung (9) zum Modulieren des ersten Ausgangssignals mit dem ersten Signal (LO1), und
eine zweite Modulationseinrichtung (10) zum Modulieren des Signals, welches durch die erste Modulationseinrichtung (9) erzeugt wird, mit dem dritten Signal (LO3'),
**dadurch gekennzeichnet, dass** die erste Offset-Schleife (6) außerdem eine zweite Teilereinrichtung (11) umfasst, um das Signal, welches durch die zweite Modulationseinrichtung (10) erzeugt wird, durch N 1 zu teilen, und
einen ersten Phasengenerator (12) zum Vergleichen des zweiten Signals, welches durch M1 geteilt ist, mit dem Signal, welches durch die zweite Modulationseinrichtung (10) erzeugt wird, welches durch N geteilt ist, und zum Regeln der Frequenz des ersten Ausgangssignals auf Basis des Vergleichs, und
dass der Frequenz-Synthesizer (1) umfasst:
eine zweite Offset-Schleife (14) zum Erzeugen eines zweiten Ausgangssignals auf Basis des ersten, zweiten und dritten Signals (LO1, LO2 und LO3'), wobei die zweite Offset-Schleife (14) umfasst:
eine dritte Teilereinrichtung (16) zum Teilen des zweiten Signals durch M2,
eine dritte Modulationseinrichtung (17) zum Modulieren des zweiten Ausgangssignals mit dem ersten Signal (LO1),
eine vierte Modulationseinrichtung (18) zum Modulieren des Signals, welches durch die dritte Modulationseinrichtung (17) erzeugt wird, mit dem dritten Signal (LO3'),
eine vierte Teilereinrichtung (19) zum Teilen des Signals, welches durch die vierte Modulationseinrichtung (18) erzeugt wird, durch N2, und
einen zweiten Phasenkomparator (20) zum Vergleichen des zweiten Signals (LO2), welches durch M2 geteilt ist, mit dem Signal, welches durch die vierte Modulationseinrichtung (18) erzeugt wird, welche durch N2 geteilt ist, und zum Regeln der Frequenz des zweiten Ausgangssignals auf Basis des Vergleichs.

2. Frequenz-Synthesizer (1) nach Anspruch 1,
**dadurch gekennzeichnet, dass**
das erste Ausgangssignal eine Frequenz gemäß der Formel LO1±LO3'+LO2/M1xN1 hat.

3. Frequenz-Synthesizer (1) nach Anspruch 1 oder 2,
**dadurch gekennzeichnet, dass**
das zweite Ausgangssignal eine Frequenz gemäß der Formel L01+LO3'+LO2/M2xN2 hat.

4. Frequenz-Synthesizer (1) nach einem der Ansprüche 1 bis 3,
**dadurch gekennzeichnet, dass**
die Signalerzeugungseinrichtung (5) eine dritte Oszillatoreinrichtung (22) umfasst, welche ein Signal mit einer Frequenz LO3 erzeugt, wobei das dritte Signal (LO3') von dem Signal mit der Frequenz LO3 hergeleitet wird.

5. Frequenz-Synthesizer (1) nach Anspruch 4,
**dadurch gekennzeichnet, dass**
die Signalerzeugungseinrichtung (5) eine fünfte Teilereinrichtung (3) umfasst, um das Signal (LO3), welches durch die dritte Oszillatoreinrichtung (22) erzeugt wird, zu teilen.

6. Frequenz-Synthesizer (1) nach Anspruch 5,
**dadurch gekennzeichnet, dass**
die fünfte Teilereinrichtung (23) das Signal (LO3), welches durch die dritte Oszillatoreinrichtung (22) erzeugt wird, durch 16 teilt.

7. Frequenz-Synthesizer (1) nach einem der Ansprüche 1 bis 6,
**dadurch gekennzeichnet, dass**
die Signalerzeugungseinrichtung (5) eine Schalteinrichtung (24) umfasst, um Signale zu erzeugen, welche phasenverzögert sind.

8. Frequenz-Synthesizer (1) nach Anspruch 7,
**dadurch gekennzeichnet, dass**
die Schalteinrichtung (24) phasenverzögerte IQ-Signale erzeugt.

9. Frequenz-Synthesizer (1) nach Anspruch 7 oder 8,
**dadurch gekennzeichnet, dass**
die Ausgangssignale der Schalteinrichtung (24) gleich dem dritten Signal (L03') sind.

10. Frequenz-Synthesizer (1) nach einem der Ansprüche 1 bis 9,
**dadurch gekennzeichnet, dass**
die erste Oszillatoreinrichtung (3) das erste Signal mit einer Frequenz LO1 im Frequenzbereich von 1540 bis 1600 MHz erzeugt, die zweite Oszillatoreinrichtung (4) das zweite Signal mit den Frequenzen L02 456, 490, 4 und 539,2 MHZ erzeugt, und die Signalerzeugungseinrichtung (5) das dritte Signal mit einer Frequenz LO3' im Frequenzbereich von 7,5 bis 10 MHz erzeugt.

11. Frequenz-Synthesizer (1) nach einem der Ansprüche 1 bis 10,
**dadurch gekennzeichnet, dass**
der Frequenz-Synthesizer (1) die Frequenz im GSM-Standard für EGSM, GSM 1800, GSM 1900 liefert.

12. Mobiles Endgerät für ein drahtloses Telekommunikationssystem nach dem GSM- und/oder UMTS-Standard, welches umfasst:
einen Frequenz-Synthesizer (1) nach einem der vorhergehenden Ansprüche.

## Revendications

1. Synthétiseur de fréquences (1) pour fournir des fréquences de réception et d'émission pour des systèmes de télécommunication sans fil selon la norme GSM - et UMTS -, comprenant
un moyen de signal de référence (2) pour générer un signal de référence (F_{ref}) avec une fréquence prédéterminée,
un premier moyen d'oscillation (3) pour générer un premier signal avec une fréquence LO1 sur la base du signal de référence (Fᵣef) ,
un deuxième moyen d'oscillation (4) pour générer un deuxième signal avec une fréquence L02 sur la base du signal de référence (F_{ref}) ,
un moyen de génération de signal (5) pour générer un troisième signal avec une fréquence L03' sur la base du signal de référence (F_{ref}) , et
une première boucle de décalage (6) pour générer un premier signal de sortie sur la base du premier, deuxième et troisième signal,
dans lequel la première boucle de décalage (6) comprend
un premier moyen de division (8) pour diviser le deuxième signal par M1,
un premier moyen de modulation (9) pour moduler le premier signal de sortie par le premier signal (LO1), et
un deuxième moyen de modulation (10) pour moduler le signal, qui est généré par le premier moyen de modulation (9), par le troisième signal (L03'),
**caractérisé en ce que** la première boucle de décalage (6) comprend en outre
un deuxième moyen de division (11) pour diviser le signal, qui est généré par le deuxième moyen de modulation (10), par N1, et
un premier comparateur de phase (12) pour comparer le deuxième signal divisé par M1 avec le signal, qui est généré par le deuxième moyen de modulation (10), divisé par N1, et pour réguler la fréquence du premier signal de sortie sur la base de la comparaison et
**en ce que** le synthétiseur de fréquences (1) comprend
une deuxième boucle de décalage (14) pour générer un deuxième signal de sortie sur la base du premier, deuxième et troisième signal (LO1, LO2 et LO3'),
dans lequel la deuxième boucle de décalage (14) comprend
un troisième moyen de division (16) pour diviser le deuxième signal par M2,
un troisième moyen de modulation (17) pour moduler le deuxième signal de sortie par le premier signal (LO1),
un quatrième moyen de modulation (18) pour moduler le signal, qui est généré par le troisième moyen de modulation (17), par le troisième signal (LO3'),
un quatrième moyen de division (19) pour diviser le signal, qui est généré par le quatrième moyen de modulation (18), par N2, et
un deuxième comparateur de phase (20) pour comparer le deuxième signal (LO2) divisé par M2 avec le signal, qui est généré par le quatrième moyen de modulation (18), divisé par N2, et pour réguler la fréquence du deuxième signal de sortie sur la base de la comparaison.

2. Synthétiseur de fréquences (1) selon la revendication 1, **caractérisé en ce que** le premier signal de sortie a une fréquence selon la formule LO1±LO3'+LO2/M1xN1.

3. Synthétiseur de fréquences (1) selon la revendication 1 ou 2, **caractérisé en ce que** le deuxième signal de sortie a une fréquence selon la formule LO1+LO3'+LO2/M2xN2.

4. Synthétiseur de fréquences (1) selon l'une des revendications 1 à 3, **caractérisé en ce que** le moyen de génération de signal (5) comprend un troisième moyen d'oscillation (22), qui génère un signal avec une fréquence LO3, moyennant quoi le troisième signal (LO3') est dérivé du signal avec la fréquence LO3.

5. Synthétiseur de fréquences (1) selon la revendication 4, **caractérisé en ce que** le moyen de génération de signal (5) comprend un cinquième moyen de division (23) pour diviser le signal (LO3) généré par le troisième moyen d'oscillation (22).

6. Synthétiseur de fréquences (1) selon la revendication 5, **caractérisé en ce que** le cinquième moyen de division (23) divise le signal (LO3) généré par le troisième moyen d'oscillation (22) par 16.

7. Synthétiseur de fréquences (1) selon l'une des revendications 1 à 6, **caractérisé en ce que** le moyen de génération de signal (5) comprend un moyen de commutation (24) pour générer des signaux qui sont à retard de phase.

8. Synthétiseur de fréquences (1) selon la revendication 7, **caractérisé en ce que** le moyen de commutation (24) génère des signaux IQ à retard de phase.

9. Synthétiseur de fréquences (1) selon la revendication 7 ou 8, **caractérisé en ce que** les signaux de sortie du moyen de commutation (24) sont égaux au troisième signal (LO3').

10. Synthétiseur de fréquences (1) selon l'une des revendications 1 à 9, **caractérisé en ce que** le premier moyen d'oscillation (3) génère le premier signal avec une fréquence LO1 dans la gamme de fréquences de 1540 à 1600 MHz, le deuxième moyen d'oscillation (4) génère le deuxième signal avec les fréquences LO2 456, 490,4 et 539,2 MHz et le moyen de génération de signal (5) génère le troisième signal avec une fréquence L03' dans la gamme de fréquences de 7,5 à 10 MHz.

11. Synthétiseur de fréquences (1) selon l'une des revendications 1 à 10, **caractérisé en ce que** le synthétiseur de fréquences (1) fournit la fréquence dans la norme GSM pour EGSM, GSM 1800, GSM 1900.

12. Terminal mobile pour un système de télécommunication sans fil selon la norme GSM - et / ou UMTS - comprenant
un synthétiseur de fréquences (1) selon l'une des revendications précédentes.
